Europäisches Patentamt

European Patent Office

Office européen des brevets

(11) Publication number: **0 478 946 A1**

# EUROPEAN PATENT APPLICATION

(21) Application number: **91114265.1**

(22) Date of filing: **26.08.91**

(51) Int. Cl.5: **H01L 27/148**

(30) Priority: **01.10.90 US 591126**

(43) Date of publication of application:
**08.04.92 Bulletin 92/15**

(84) Designated Contracting States:
**DE FR GB NL**

(71) Applicant: **POLAROID CORPORATION**
**549 Technology Square**
**Cambridge Massachusetts 02139(US)**

(72) Inventor: **Bencuya, Selim S.**
**85 Saco Street**
**Newton, MA 02164(US)**
Inventor: **Hsieh, Tzu Chiang**
**10 Post Oak Lane**
**Natick, MA 01760(US)**
Inventor: **McGrath, R. Danien**
**19 Canterbury Street**
**Andover, MA 01810(US)**
Inventor: **Metz, Werner**
**57 Tea Street**
**Stoughton, MA 02072(US)**

(74) Representative: **Koch, Günther, Dipl.-Ing.**
**Patentanwälte Wallach, Koch, Dr. Haibach,**
**Feldkamp et al**
**P.O. Box 121120**
**W-8000 München 12(DE)**

(54) CCD frame transfer image device.

(57) A charge coupled imaging device comprises a substrate of first conductivity type and an overlying well layer of a second opposite conductivity type first formed as an unpatterned layer. A charge transfer channel layer of the first conductivity type is also first formed as an unpatterned layer and longitudinal spaced apart channel stop regions of the second conductivity type are patterned to overlie the well layer and are in contact therewith. The substrate, the channel stops, and the well are preferably biased with respect to each other so as to effect complete charge depletion in the charge transfer and well regions for providing a vertical antiblooming drain to the substrate. A feature of the invention is a two layer electrode arrangement in which alternate electrodes transversely overlie the channels and the channel stops and are insulated therefrom and each other. Output registers at the end of the charge transfer channels provide a read out of multiple phases of the channels in ordered sequence.

FIG. 1

## BACKGROUND OF THE INVENTION:

### 1. Field of the Invention:

This invention relates generally to a frame transfer charge-coupled device (CCD) and, more particularly, to a frame transfer charge-coupled device in which the well and charge transfer regions are first formed as unpatterned regions and further comprising an improved electrode structure which results in an imaging device with good optical and electrical performance and vertical antiblooming characteristics and improved read out.

### 2. Description of the Prior Art:

Charge coupled imaging devices of the frame-transfer type comprising a plurality of elongated radiation or photosensitive portions arranged in columns are well known in the art. In said devices charge transport channels arranged side by side in parallel columns are electrically separated by channel stops. Incident scene light operates to photogenerate minority charge carriers in the radiation sensitive portion in the charge transport channels. A complex system of electrodes insulated from the channels effects charge transport along the channels to an output register which reads out the channels serially for further processing.

Fabrication of such devices involves complex and exacting processing steps. In particular, processing of the charge transfer regions and the channel stops is complicated by the requirements for the electrode layout. Read out is also compromised or made more difficult by complex electrode schemes for the region between the imaging region and the output register. Further shortcomings of the art are apparent in the complexity of implementation and the effectiveness of various antiblooming techniques.

It is therefore a primary object of this invention to fabricate a charge-coupled device using a simplified process.

It is another object of the invention to provide a CCD with vertical antiblooming.

It is another object of the invention to provide a CCD in which the imaging region is fabricated by a simplified process comprising a series of unpatterned implants or dopings and a single patterned implant or doping.

It is yet another object of the invention to provide a CCD in which the electrode structure and layout is simplified thereby allowing good optical response.

It is another object of the invention to provide a CCD with effective read out using the same simplified processes as used to fabricate the imaging region.

It is another object of the invention to provide a CCD with a selective readout arrangement.

## SUMMARY OF THE INVENTION:

A charge coupled imaging device of the frame transfer type comprises a semiconductor substrate of first conductivity type and an overlying well layer of a second opposite conductivity type first formed as an unpatterned layer. A charge-transfer channel layer of the first conductivity type overlies the well layer and is also first formed as an unpatterned layer. Longitudinal spaced apart channel stop regions of the second conductivity type are patterned to overlie the well layer and are in contact therewith. The substrate, the channel stops, and the well are preferably biased with respect to each other so as to effect complete charge depletion in both the well and charge transfer channel regions for providing a vertical antiblooming channel to the substrate which operates as a drain.

A feature of the invention is a two layer electrode arrangement in which alternate electrodes transversely overlie the channels and the channel stops and are insulated therefrom and each other. An output register and a two layer output electrode structure at one end of the charge transfer channels provide a read out of selected channels in ordered sequence.

## DESCRIPTION OF THE DRAWINGS:

Fig. 1 is a fragmentary schematic cross section of a charge coupled imaging device according to the present invention;

Fig. 2 is a top plan view of an electrode arrangement in accordance with the present invention;

Fig. 3 is a cross sectional view of the arrangement of Fig. 2 along lines 3-3 thereof;

Fig. 4 is a cross sectional view of the arrangement of Fig. 2 taken along lines 4-4 thereof;

Fig. 5 is a cross sectional view of the arrangement of Fig. 2 taken along lines 5-5 thereof;

Fig. 6 is a plot of equipotential lines in a device prepared in accordance with the teachings of the present invention;

Fig. 7 is a plot of potential through the charge transport region and the well vs. distance from the top of the device with net doping profile superimposed thereon; and

Fig. 8 is a vertical profile of individual and net impurity concentrations through the center of a channel stop, the well and the substrate.

Fig. 9 is a top plan view of an alternative electrode arrangement of the present invention;

## DESCRIPTION OF THE PREFERRED EMBODIMENT:

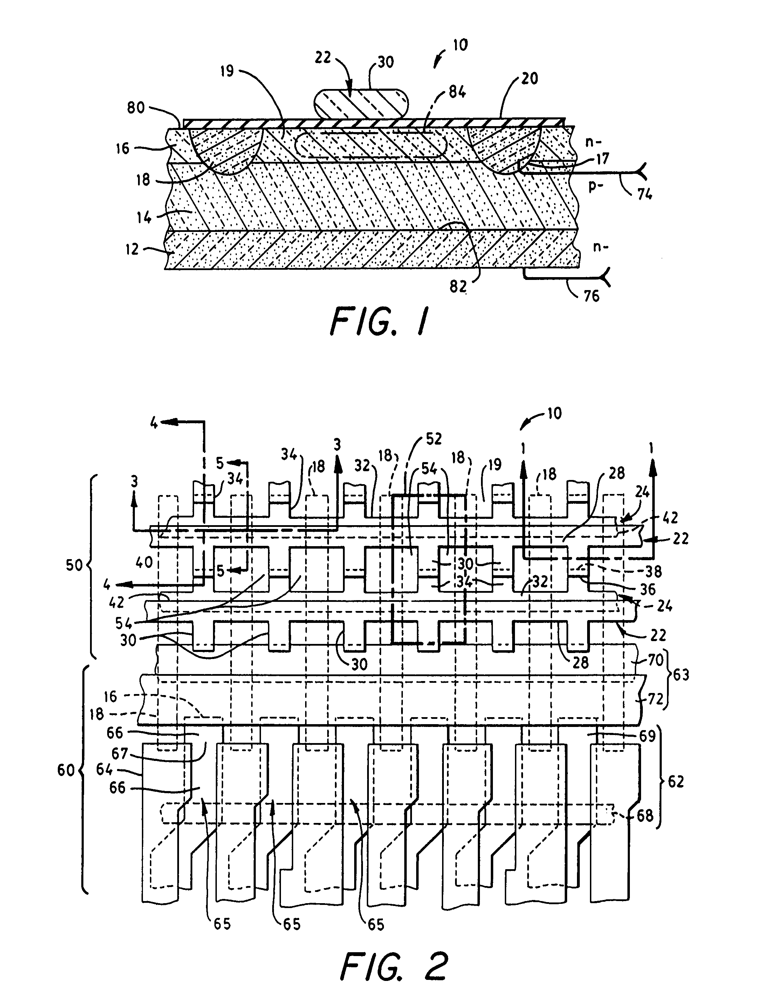

Referring to the drawings, a charge coupled imaging device 10 having an imaging region 50 and an output region 60 in accordance with the present invention is illustrated in Figs. 1-5. The device 10 comprises a substrate 12 of a first conductivity type and an overlying well layer 14 of a second opposite conductivity type first formed as an unpatterned uniform layer. For example, the substrate 12 may be an n type material and the well may be a p type material. A charge transfer layer 16 of the first conductivity type overlies the well layer and is also first formed as an unpatterned uniform layer. In the imaging area 50 longitudinal spaced apart channel stop regions 18 of the second conductivity type are patterned to overlie and make contact at interface 17 with the well region 14. The channel stop regions 18 define channels 19 therebetween. In a preferred embodiment the channel stop regions 18 may have a graded profile from relatively heavy $p^+$ doping near an upper surface to a relatively light $p^-$ doping near the well 14. Doping of the channel stop 18 and well 14 may match at their contacting interface 17. An insulating layer 20 overlies the charge transfer region 16 and channel stop region 18. Electrodes 22 and 24 overlie the insulating layer 20 and extend transversely of the channel stop regions 18 as well as longitudinally of the device 10. The electrodes 22 and 24 are likewise insulated from each other by insulating layer 26.

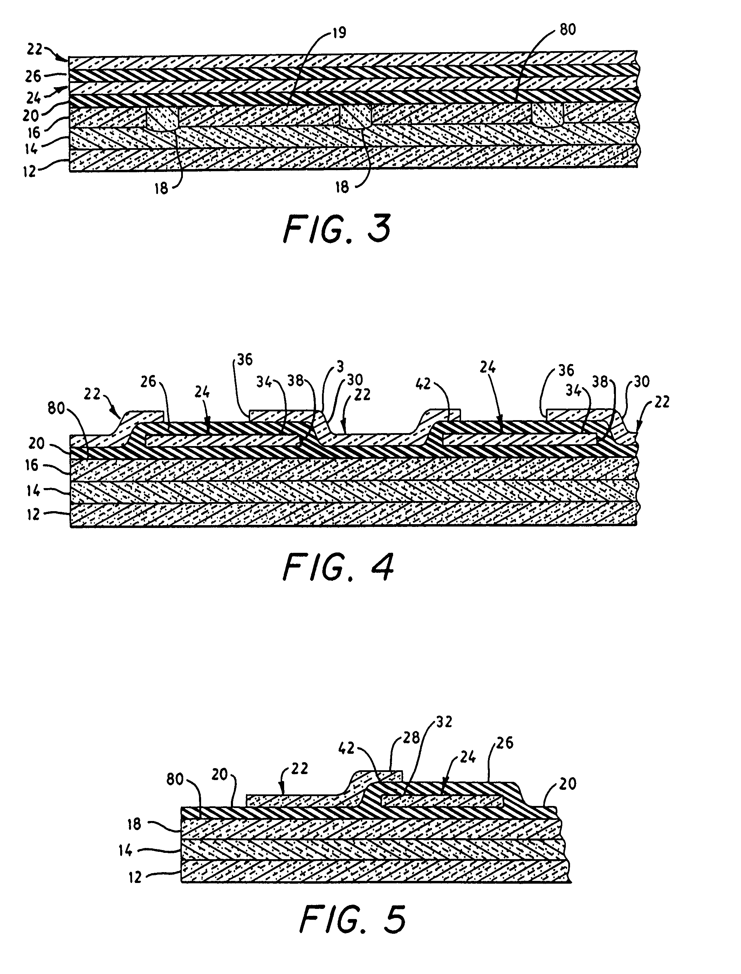

Each electrode 22 has a transverse portion 28 which extends transversely across the charge transfer regions 16 and the channel stop regions 18. In the arrangement illustrated in Fig. 2, depending electrode fingers 30 extend from the transverse portion 28 of each electrode 22 in a direction longitudinally of the channels 19 in the charge transfer region 16 as shown. The electrodes 24 are alternately spaced between the electrodes 22. Each electrode 24 includes a transverse portion 32 which likewise lies transversely of the well and channel stops 18, as shown, and depending electrode fingers 34 which extend longitudinally of the channels 19 in the charge transport region 16. The fingers 30 and 34 of the respective electrodes 22 and 24 are in alignment such that their respective distal ends 36 and 38 overlap as best shown in Fig. 2. Likewise, the transverse portion 28 of each succeeding electrode 22 overlaps with the transverse portion 32 of the next succeeding electrode 24 in transverse interelectrode region 42 as best shown in Fig. 5. In accordance of the present invention each of the first electrodes 22 and 24 may independently form a separate phase $\phi_1...\phi_2...\phi_n$, such that, three or preferably four phase clocking may be provided with only two electrode sets which are mutually insulated from each other and from the channels 19 and channel stops 18. See, for example, Fig. 4.

In accordance with the present invention the imaging region 50 contains a plurality of rows and columns of pixels one of which is shown outlined at 52 in Fig. 2. The pixels 52 occupy the area in the channels 19 between channel stops 18 in the lateral direction, and between the overlapping transverse interelectrode regions 42 in the longitudinal direction. The electrode structure of the present invention provides open window areas 54 which are divided by the overlapping fingers 30 and 34 as shown. The open window areas 54 allow for efficient photogeneration of charge carriers.

The output region 60 comprises a serial output register 62 having register stages 65 formed by pairs of two level register electrodes 64 and 66 and a transfer register 63 formed of two level transfer electrodes 70 and 72. The register electrodes 64 and 66 are formed in the charge transfer layer at the ends 69 of the channel stops 18 and the channels 19. Each pair of register electrodes 64 and 66 can be commonly connected electrically and form one register gate 67 from the adjacent channel 19 into the proximate register stage 65 of the serial register 62. The paired register electrodes are disposed on the insulating layer 20 and separated by insulation 26 in overlapping relation in a two level geometry similar to the electrodes 22 and 24 described above.

A register channel stop 68 which may be formed of p type material in the channel layer 16 defines one boundary of the serial output register 62. The ends 69 of the channels 19 define the other boundary of the serial register 62.

Transfer electrodes 70 and 72 overlie the channels 19 and the channel stops 18 adjacent the serial output register 62 and effect parallel transfer of charge from the channels 19 to selected inputs of the serial register 62. The transfer electrodes 70 and 72 overlie the insulating layer 20 and are insulated from each other by insulation 26 in a two level geometry.

After exposure of the device 10 to scene light, photogenerated charge produced in the imaging region is clocked, horizontal row-by-row into the transfer register 63 by selective activation of the electrodes 22 and 24 in a phased sequence. Charge from each row of pixels 52 is clocked through transfer register 63 one row at a time and selectively held under the electrodes 70 and 72 prior to entering the serial register 62.

In the arrangement described, the charge is transferred from the parallel channels 19 to the output register 62 in an ordered sequence. For example, after the charge from a rob of pixels is entered into the transfer register 63 and with the transfer electrodes 70 and 72 thereof driven high, every third register gate 67 of the output register 62 is driven high while all the remaining two-thirds register gates 67 are driven low. Charge in the transfer register 63 from the selected one-third channels 19 thus enters the corresponding stages 65 of the output register 62. Thereafter, transfer electrode 72, nearest the register gates 67, is driven low which thereby causes the remaining charge in the transfer register 63 to be driven back one phase therein to the electrode 70 whereby the charge held in the transfer register 63 is isolated from influence by the register gates 67. Thereafter, the output register gates 67 are clocked phase by phase to serially remove charge laterally out of the transfer register 63. At this point every third pixel in the row is clocked out. This may correspond, for example, to one color if the pixels are overlaid with color stripe filters as is well known in the art.

After transfer of the charge from the first group of pixels is complete, the transfer electrode 72 goes high thereby moving charge to the input of the output register 62. A next group of every third register gates 67 is then driven high to remove charge from the transfer register 63. Again thereafter, electrode 72 is driven low which causes the remaining charge to move back in the transfer register 63 while the output register 62 is clocked out. This process is repeated for a third time to clear the remaining charge for the row of pixels. The entire process is repeated for each row of pixels sequentially. As a result read out by individual color is possible, that is all the pixels of one color in a row are read out, then all the pixels of the second color in the same row are read out and so on. Connections of the register gates 67 determine whether the charge read out is every other column, every third column and so on. Alternative clocking schemes of course are possible depending upon the arrangement of electrode connections desired.

In addition, as will be readily understood, charge storage areas may be provided between the imaging region 50 and the output region 60.

Having described the physical arrangement of the charge coupled image device of the present invention a more detailed description follows.

In accordance with the invention, it is desirable to greatly simplify the process of device fabrication by first fabricating the well 14 as an unpatterned uniform layer. The charge transfer layer 16 is also first fabricated as an unpatterned uniform layer. Substrate 12 may be formed of n type materials such as n doped single crystal silicon by known techniques. Well 14 which may be p doped is formed as an unpatterned uniform layer by any well-known method such as a conventional implant and drive process, a high energy implant and anneal process or epitaxial growth of a lightly doped $p^-$ layer on the $n^+$ substrate 12. The unpatterned well 14 obviates the need for critical well patterning and alignment steps as in prior arrangements and allows a noncritical large geometry. It further eliminates a graded well process sequence with critical thermal drives having no analog in standard integrated circuit processing and allows more latitude in pixel design.

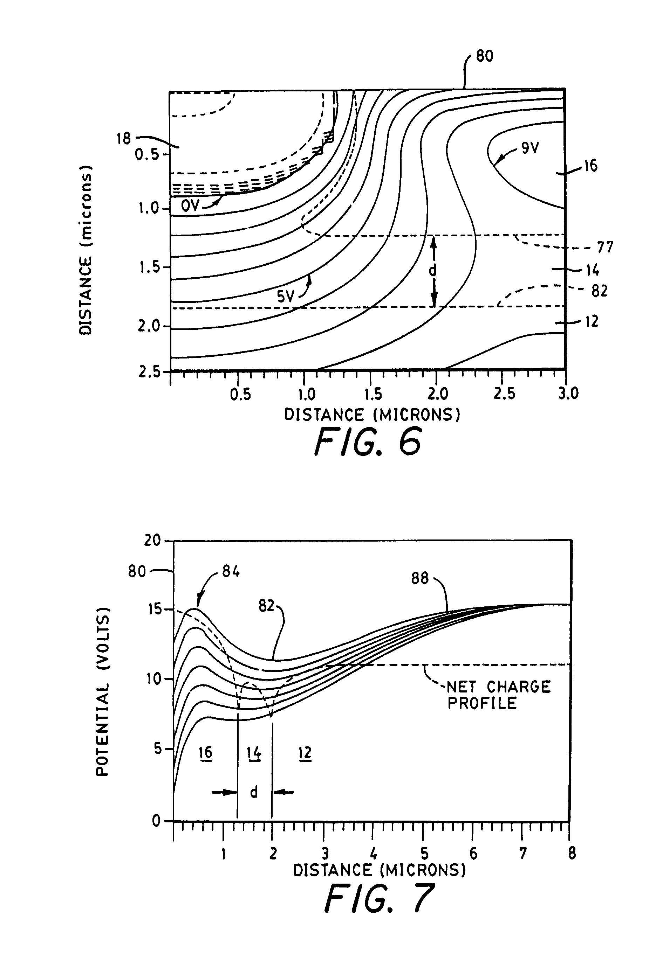

The charge transfer layer 16 is also formed as an unpatterned uniform sheet on the well layer 14 using either implantation or epitaxy techniques as referred to above. If the well 14 is formed epitaxially, for example, then it is possible to form the charge transfer layer 16 in the same process step by altering the dopant introduced into the ambient during growth. The channel stops 18 and 68 are thereafter implanted using a photomask (not shown) to provide isolation between adjacent channels 19 in the charge transfer layer 16. In accordance with an embodiment of the invention shown in Fig. 1, the $p^+$ channel stop regions 18 may be graded to allow for gradually changing electric fields. Fig. 6 graphically illustrates the concept.

The channel stop regions 18 are implanted to a depth in the channel layer 16 such that each contacts the well 14 at interface 17. As hereinafter described, this arrangement allows for a controlled biasing arrangement resulting in carrier depletion in the well 14 which allows for efficient vertical antiblooming.

The insulating dielectric 20 may be thereafter formed over the channel 16 as shown. The insulating dielectric may comprise silicon oxide, or a combination of silicon oxide and silicon nitride or other insulating materials known to the art. Two level gate electrodes 22 and 24 may be formed with an intermediate insulating layer 26 of silicon oxide or silicon nitride or a combination of silicon oxide and silicon nitride to complete the device 10. Additional unpatterned implants may be used to adjust the surface thresholds in a manner well known in the art. Separate channel stop biasing electrodes 74 and a substrate biasing electrode 76 may be formed by known techniques for contacting the channel stops 18 and substrate 12, respectively, and applying a bias thereon.

In an embodiment of the invention, the substrate 12 is positively biased with respect to the electrodes 22 and 24, and the substrate 12 and the electrodes 22 and 24 are biased positively with respect to channel stops 18. Given the material types and biasing, i.e., n type substrate 12, p type channel stops 18 and p type P-well 14 there results a reverse bias semiconductive junction or barrier 82 between the well 14 and the substrate 12. The channel stops 18 are also reverse biased with respect to the substrate 12 and the charge-transfer layer 16. When excess photogenerated charges are produced in well 14 or charge transfer channel 19 the reverse bias is overcome and the excess charge flows vertically into the substrate 12. Otherwise, photogenerated charge flows in the channels 19.

Fig. 7 graphically illustrates the concept by means of a plot of potential versus distance from the top surface 80 of the device 10. Normally, charge resides close to the surface 80 of the device in region 84, as shown in Fig. 7. As photogenerated charges increase, the reverse bias semiconductive junction or barrier region 82 is reduced and the charge tends to be attracted to the higher potential region 88 further from the surface of the device. The cusps in the net charge profile depict the interfaces at the channel 14 and substrate 12 in the barrier region 82. As the charge increases, the barrier is overcome and the excess charge moves towards the substrate, that is to the right in Fig. 7. The net impurities change gradually and form an antiblooming surface 77 as shown in Fig. 6 between the channels 16 and the well region 14. The antiblooming surface 77 within each pixel 52 effects improved vertical antiblooming. In prior arrangements, the impurity levels are nonuniform and thus result in a linear antiblooming site as opposed to a substantially uniform two dimensional surface.

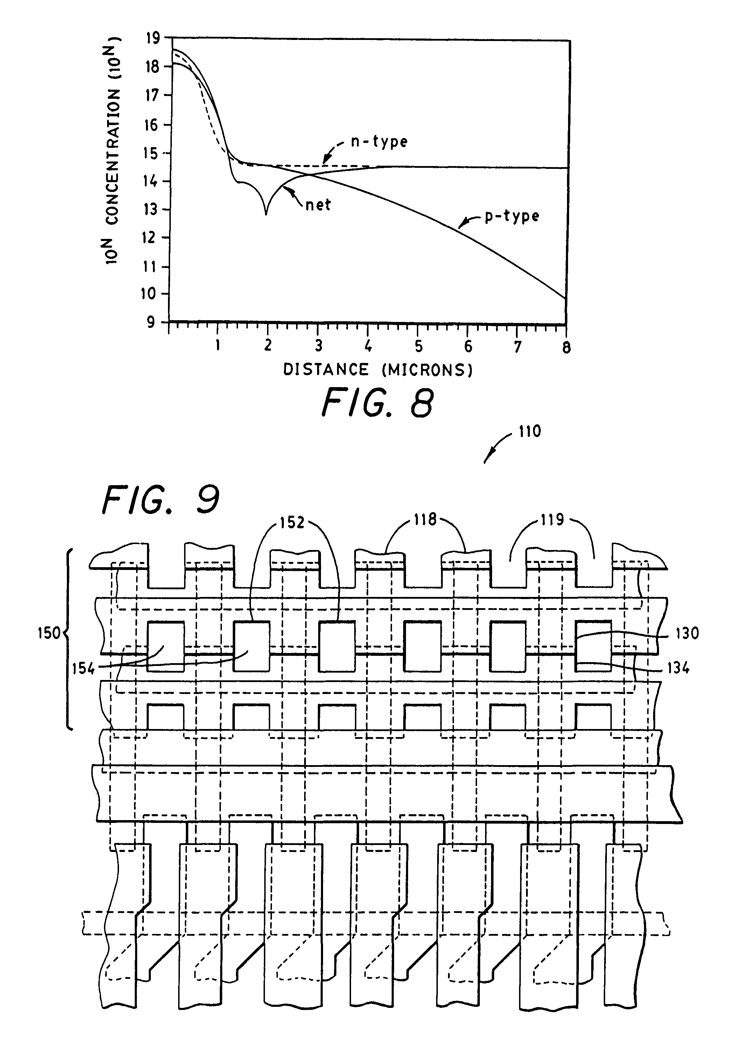

Fig. 8 shows the plot of individual and net impurities across the device versus distance from the upper surface 80 centered through the channel stop 18. The n and p type impurities are labeled as well as the net impurities.

In an alternate embodiment of the present invention illustrated in Fig. 9, device 110 has an imaging region 150 which is provided with a plurality of rows and columns of pixels 152 located between channel stops 118. In the alternative embodiment the fingers 130 and 134 overlie the channel stops 118 and thereby provide open window areas 154 which reside within the boundaries of the channels 119 defined by the adjacent channel stops 118. The open window areas 154 thus allow for more uniform photogeneration of charge carriers because the overlapping fingers 130 and 134 are located within the channel stops 118 and thus increase the optical response of the incident scene light impinging on the device.

As will be readily apparent to those of ordinary skill in the art, the overlapping fingers of the electrodes 22, 24 may be located at any position intermediate the positions as shown in the embodiments of Figures 2 and 9.

In accordance with the present invention in a preferred embodiment the charge coupled imaging device 10 employs vertical antiblooming in the imaging region 50. The well layer 14 and charge transfer layer 16 which are first formed as unpatterned uniform layers can be arranged in a noncritical large geometry. The channel stops 18 are in contact with the well and are graded to reduce electric fields in the device 10. Two level gate electrodes 22, 24 with open optical windows 54 in the channels 19 are provided. Transverse portions 28 and 32 of successive electrodes 22 and 24 are overlapping in a back to back configuration, and the fingers 30 and 34 of adjacent electrodes overlap. Multiple phased read out is employed with only two gate electrodes thereby greatly simplifying fabrication. The output region 60 has a transfer register 63 and a serial output register 62 which provide read out with two level electrode geometry.

While there has been described what at present are considered to be the preferred embodiments of the present invention it will be apparent to those skilled in the art that various changes and modifications may be made therein without departing from the invention and it is intended in the accompanying claims to cover all such changes and modifications as forward in the true spirit and scope of the invention.

**Claims**

1. A charge coupled frame transfer imaging device having select imaging and transfer areas comprising:

   a substrate of a first conductivity type;

   an overlying well layer of a second conductivity type opposite the first conductivity type and first formed as an unpatterned layer;

   a charge transfer layer of the first conductivity type overlying the well layer of the second conductivity type and first formed as an unpatterned layer;

   longitudinal, spaced apart patterned channel stop regions of the second conductivity type formed in the charge transfer layer defining charge transfer channels therebetween and being in contact with the well layer;

   a first insulating layer overlying the charge transfer layer;

   a two-level gate electrode means overlying the first insulating layer; and,

   electrical contacts connecting, respectively, to the channel stop regions and the substrate to accommodate the biasing of the device.

2. The device of claim 1 wherein the two-level gate electrode means includes a plurality of first conductive portions alternately spaced at two levels with an intermediate second insulating layer therebetween and extending transverse to the channel stop regions in spaced apart relation to each other, each of said first conductive portions connecting, respectively, to a second conductive portion comprising a plurality of electrode fingers projecting in directions parallel to the channel stop regions.

3. The device of claim 2 wherein the distal portion of each electrode finger from each succeeding first conductive portion overlaps the distal portion of each respective electrode finger from the next succeeding first conductive portion.

4. The device of claim 3 wherein the first insulating layer comprises silicon oxide or silicon nitride or any combination of silicon oxide and silicon nitride and the second insulating layer comprises silicon oxide or silicon nitride or any combination of silicon oxide and silicon nitride.

5. The device of claim 1 wherein the channel stop regions are doped in a gradient having a varying dopant concentration such that the interface between the channel stop regions and the well layer are doped to substantially the same concentration.

6. The device of claim 5 wherein the well layer is p doped and the channel stop regions comprise regions graded from a p + dopant closest to the outer surface of the device to a p- at the interface with the p well layer.

7. The device Of claim 1 further including means for biasing the electrical contacts such that the substrate is reverse biased with respect to the well layer and the channel stop regions are reverse biased with respect to the substrate and charge-transfer layer.

8. The device of claim 7 wherein the well layer and charge transfer layer each has a selected thickness and the biasing means is selected to provide a biasing voltage with respect to said selected thicknesses so as to establish a potential sufficient to result in a substantially completely depleted region in the charge transfer channel and in the well region.

9. The device of claim 1 further comprising transfer register means extending transverse to the channels adjacent one end thereof for selectively storing charge thereunder, said transfer register means comprising at least two elongated transfer electrodes overlapping in a two level geometry in said transfer area.

10. The device of claim 9 further comprising serial output register means extending transverse to the charge transfer channels and operatively coupled to said transverse register means for advancing charges received from the charge transfer channels by way of the transfer register to an output, said serial output register comprising multiple stages formed of two level electrode means overlying the insulating layer in the charge transfer area.

11. The device of claim 10 wherein the two level electrode means of the serial output register comprises a pair of electrodes for each channel and adjacent channel stop.

12. The device of claim 11 including means for selectively biasing the electrodes in the transfer and output registers such that selected charges stored under a first one of the electrodes of the transfer register are advanced to the output register and nonselected charges are thereafter advanced for storage under a second other electrode of the transfer register, the first electrode of the transfer register being in operative connection with the serial output register and the second electrode of the transfer register being isolated from the operation of the serial output register thereby allowing the transfer of selected charges from the transfer register by way of the serial output register.

13. A charge coupled frame transfer imaging device having select imaging and transfer areas comprising:
    a substrate of a first conductivity type;
    an overlying well layer of a second conductivity type opposite to the first conductivity type;
    a charge transfer layer of the first conductivity type overlying the well layer;
    longitudinal spaced apart channel stop regions of the second conductivity type in the charge transfer layer defining charge transfer channels therebetween and being in contact with the well layer;
    a first insulating layer overlying the charge transfer layer;
    a two level gate electrode means overlying the first insulating layer comprising a plurality of first conductive portions alternately spaced at two levels with an intermediate second insulating layer therebetween and extending transverse to the channel stop regions in spaced apart relation to each other, each of said first conductive portions connecting, respectively, to a second conductive portion comprising a plurality of electrode fingers projecting in directions parallel to the channel stop regions; and
    electrical contacts connecting, respectively, to the channel stop regions and the substrate to accommodate the biasing of the device.

14. The device of claim 13 wherein the distal portion of each electrode finger from each succeeding first conductive portion overlaps the distal portion of each respective electrode finger from the next succeeding first conductive portion.

15. The device of claim 14 wherein the first insulating layer comprises silicon oxide or silicon nitride or any combination of silicon oxide and silicon nitride and the second insulating layer comprises silicon oxide or silicon nitride or any combination of silicon oxide and silicon nitride.

16. The device of claim 14 wherein the channel stop regions are doped in a gradient having a varying dopant concentration such that the interface between the channel stop regions and the well layer are doped to substantially the same concentration.

17. The device of claim 16 wherein the well layer is p doped and the channel stop regions comprise regions graded from a p+ dopant closest to the outer surface of the device to a p- at the interface with the p well layer.

18. The device of claim 14 further including means for biasing the electrical contacts such that the substrate is reverse biased with respect to the well layer and the channel stop regions are reverse biased with respect to the substrate and charge-transfer layer.

19. The device of claim 18 wherein the well layer and charge transfer layer each has a selected thickness and the biasing means is selected to provide a biasing voltage with respect to said selected thicknesses so as to establish a potential sufficient to result in a substantially completely depleted region in the charge transfer channel and in the well region.

20. The device of claim 14 further comprising transfer register means extending transverse to the channels adjacent one end thereof for selectively storing charge thereunder, said transfer register means comprising two or more elongated transfer electrodes overlapping in a two level geometry in said transfer area.

21. The device of claim 20 further comprising serial output register means extending transverse to the charge transfer channels and op-

eratively coupled to said transverse register means for advancing charges received from the charge transfer channels by way of the transfer register to an output, said serial output register comprising multiple stages formed of two level electrode means overlying the insulating layer in the charge transfer area.

22. The device of claim 21 wherein the two level electrode means of the serial output register comprises a pair of electrodes for each channel and adjacent channel stop.

23. The device of claim 22 including means for selectively biasing the electrodes in the transfer and serial output registers such that selected charges stored under a first one of the electrodes of the transfer register are advanced to the serial output register and nonselected charges are thereafter advanced to for storage under a second other electrode of the transfer register, the first electrode of the transfer register being in operative connection with the serial output register and the second electrode of the transfer register being isolated from the operation of the serial output register thereby allowing the transfer of selected charges from the transfer register by way of the serial output register.

24. A charge-coupled frame transfer imaging device having select imaging and transfer areas comprising:
    a substrate of a first conductivity type;
    an overlying well layer of a second conductivity type opposite to the first conductivity type;
    a charge transfer layer of the first conductivity type overlying the well layer;
    longitudinal spaced apart channel stop regions of the second conductivity type in the charge transfer layer defining charge transfer channels therebetween and being in contact with the well layer, wherein the channel stop regions are doped in a gradient having a varying dopant concentration such that the interface between the channel stop regions and the well layer are doped to substantially the same concentration;
    a gate electrode means overlying the first insulating layer; and
    electrical contacts connecting, respectively, to the channel stop regions and the substrate to accommodate the biasing of the device.

25. The device of claim 24 wherein the gate electrode means is two levels and included a plurality of first conductive portions alternately spaced at two levels with an intermediate second insulating layer therebetween and extending transverse to the channel stop regions in spaced apart relation to each other, each of said first conductive portions connecting, respectively, to a second conductive portion comprising a plurality of electrode fingers projecting in directions parallel to the channel stop regions.

26. The device of claim 25 wherein the distal portion of each electrode finger from each succeeding first conductive portion overlaps the distal portion of each respective electrode finger from the next succeeding first conductive portion.

27. The device of claim 26 wherein the first insulating layer comprises silicon oxide or silicon nitride or any combination of silicon oxide and silicon nitride and the second insulating layer comprises silicon oxide, silicon nitride or any combination of silicon oxide and silicon nitride.

28. The device of claim 24 wherein the well layer is p doped and the channel stop regions comprise regions graded from a p+ dopant closest to the outer surface of the device to a p- at the interface with the p well layer.

29. The device of claim 24 further including means for biasing the electrical contacts such that the substrate is reverse biased with respect to the well layer and the channel stop regions are reverse biased with respect to the substrate and charge-transfer layer.

30. The device of claim 29 wherein the well layer and charge transfer layer each has a selected thickness and the biasing means is selected to provide a biasing voltage with respect to said selected thicknesses so as to establish a potential sufficient to result in a substantially completely depleted region in the charge transfer channel and in the well region.

31. The device of claim 24 further comprising transfer register means extending transverse to the channels adjacent one end thereof for selectively storing charge thereunder, said transfer register means comprising at least two elongated transfer electrodes overlapping in a two level geometry in said transfer area.

32. The device of claim 31 further comprising serial output register means extending transverse to the charge transfer channels and op-

eratively coupled to said transverse register means for advancing charges received from the charge transfer channels by way of the transfer register to an output, said serial output register comprising multiple stages formed of two level electrode means overlying the insulating layer in the charge transfer area.

33. The device of claim 32 wherein the two level electrode means of the serial output register comprises a pair of electrodes for each channel and adjacent channel stop.

34. The device of claim 33 including means for selectively biasing the electrodes in the transfer and serial output registers such that selected charges stored under a first one of the electrodes of the transfer register are advanced to the serial output register and nonselected charges are thereafter advanced for storage under a second other electrode of the transfer register, the first electrode of the transfer register being in operative connection with the serial output register and the second electrode of the transfer register being isolated from the operation of the serial output register thereby allowing the transfer of selected charges from the transfer register by way of the serial output register.

35. A charge-coupled frame transfer imaging device having select imaging and transfer areas comprising:

a substrate of a first conductivity type;

an overlying well layer of a second conductivity type opposite to the first conductivity type;

a charge transfer layer of the first conductivity type overlying the well layer of the second conductivity type;

longitudinal spaced apart channel stop regions of the second conductivity type formed in the charge transfer layer defining charge transfer channels therebetween and being in contact with the well layer;

a first insulating layer overlying the charge transfer layer;

a gate electrode means overlying the first insulating layer;

electrical contacts connecting, respectively, to the channel stop regions and the substrate to accommodate the biasing of the device;

transfer register means extending transverse to the channels adjacent one end thereof for selectively storing charge thereunder, said transfer register means comprising at least two elongated transfer electrodes overlapping in a two level geometry in said transfer area; and

serial output register means extending transverse to the charge transfer channels and operatively coupled to said transverse register means for advancing charges received from the charge transfer channels by way of the transfer register to an output, said serial output register comprising multiple stages formed of two level electrode means overlying the insulating layer in the charge transfer area.

36. The device of claim 35 wherein the two level electrode means of the serial output register comprises a pair of electrodes for each channel and adjacent channel stop

37. The device of claim 36 including means for selectively biasing the electrodes in the transfer and serial output registers such that selected charges stored under a first one of the electrodes of the transfer register are advanced to the serial output register and nonselected charges are thereafter advanced for storage under a second other electrode of the transfer register, the first electrode of the transfer register being in operative connection with the serial output register and the second electrode of the transfer register being isolated from the operation of the serial output register thereby allowing the transfer of selected charges from the transfer register by way of the serial output register.

FIG. 1

FIG. 2

FIG. 3

FIG. 4

FIG. 5

FIG. 6

FIG. 7

FIG. 8

FIG. 9

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | GB-A-2 069 759   (N.V. PHILIPS' GLOEILAMPEN-FABRIKEN) | 1,2,9 | H 01 L 27/148 |
| A | (* page 3, line 25 - line 35; figures 1-3 * ) <br> * abstract * * | 3-8,10-37 | |
| | – – – | | |
| Y | EP-A-0 224 993   (SHARP KABUSHIKI KAISHA) | 1,2,9 | |
| A | (* column 6, line 47 - line 54; figure 1 * ) <br> * abstract * * | 3-8,10-37 | |
| | – – – | | |
| Y | GB-A-2 134 710   (N.V. PHILIPS' GLOEILAMPEN-FABRIEKEN) | 2 | |
| A | (* page 3, line 51 - line 95; figures 1-5 * ) <br> * abstract * * | 3-37 | |
| | – – – | | |
| Y | US-A-4 206 371   (WEIMER) | 9 | |
| A | (* abstract; figure 7 *) | 10,20,31, 35 | |
| | – – – | | |
| A | WO-A-8 905 039   (EASTMAN KODAK COMPANY) <br> * abstract * * | 1-37 | |
| | – – – | | TECHNICAL FIELDS SEARCHED (Int. Cl.5) |
| A | PATENT ABSTRACTS OF JAPAN vol. 9, no. 159 (E-326)(1882) 4 July 1985 <br> & JP-A-60 038 869 ( NIPPON DENKI K.K. ) <br> * abstract * * | 3,4, 14-23, 25-27 | H 01 L |
| | – – – | | |
| A | US-A-3 971 003   (KOSONOCKY) <br> * column 4, line 59 - column 5, line 34; figures 4,6,7 * * | 10-12, 20-23, 31-37 | |
| | – – – – – | | |

The present search report has been drawn up for all claims

| Place of search | Date of completion of search | Examiner |
|---|---|---|
| The Hague | 26 November 91 | ONSHAGE A.C |